# EUROPEAN PATENT APPLICATION

(11) **EP 4 676 182 A1**
(43) Date of publication of application: **07.01.2026**
(21) Application number: 23925210.9
(22) Date of filing: 28.02.2023
(51) Int. Cl.: H10B 43/40, H01L 21/336, H01L 29/788, H01L 29/792, H10B 43/27

(54) **SEMICONDUCTOR STORAGE DEVICE AND MANUFACTURING METHOD THEREOF**

(71) Applicant: Kioxia Corporation, Tokyo 108-0023 (JP)
(72) Inventor: YAMASAKI Hiroyuki, Tokyo 108-0023 (JP); TAGAMI Masayoshi, Tokyo 108-0023 (JP); IWASAKI Taichi, Tokyo 108-0023 (JP)
(74) Representative: Marks & Clerk LLP
(86) International application number: PCT/JP2023/007259
(87) International publication number: WO 2024/180653

(57) **Abstract**

A semiconductor manufacturing device in which a pad can be easily formed on a contact plug and a manufacturing method thereof are provided. A semiconductor storage device according to the present embodiment includes a first chip including a transistor and a second chip including a memory cell array. The second chip has a first surface bonded to the first chip and a second surface opposite the first surface. A contact extends between the first surface and the second surface and is provided apart from the memory cell array. A first wiring layer is provided above a first end of the contact, which is an end on a second surface side, and is electrically connected to the contact. A first conductive layer is provided between the first end of the contact and the first wiring layer.

## Description

### Field

The embodiments of the present invention relate to a semiconductor storage device and a manufacturing method thereof.

### Background

A semiconductor storage device such as a NAND flash memory may have a configuration in which a circuit chip and a memory chip are bonded to each other. In this case, it may be difficult to form a pad on a contact plug that is connected to the circuit chip via the memory chip.

### Citation List

### Patent Literatures

Patent Literature 1: U.S. Patent Publication No. 2022/0059481
Patent Literature 2: U.S. Patent Publication No. 2022/0068858
Patent Literature 3: U.S. Patent Publication No. 2022/0077090
Patent Literature 4: U.S. Patent Publication No. 2021/0082877
Patent Literature 5: U.S. Patent Registration No. 11088113
Patent Literature 6: U.S. Patent Registration No. 10026769
Patent Literature 7: U.S. Patent Publication No. 2019/0279952

### Summary

### Technical Problem

A semiconductor manufacturing device in which a pad can be easily formed on a contact plug and a manufacturing method thereof are provided.

### Solution to Problem

According to the present embodiment, a semiconductor storage device comprises a first chip including a transistor and a second chip including a memory cell array. The second chip includes a first surface bonded to the first chip and a second surface opposite the first surface. A contact extends between the first surface and the second surface and is provided apart from the memory cell array. A first wiring layer is provided above a first end of the contact and electrically connected to the contact, the first end being an end on a second surface side. A first conductive layer is provided between the first end of the contact and the first wiring layer.

### Brief Description of Drawings

[FIG. 1] FIG. 1 is a block diagram illustrating a configuration of a semiconductor storage device.
[FIG. 2] FIG. 2 is a circuit diagram illustrating a configuration of a block.
[FIG. 3] FIG. 3 is a plan view illustrating a configuration example of a chip according to a first embodiment.
[FIG. 4] FIG. 4 is an X-Z cross-sectional view illustrating a configuration of the semiconductor storage device.
[FIGS. 5] FIGS. 5 are cross-sectional views illustrating a configuration of a memory cell.
[FIG. 6] FIG. 6 is a cross-sectional view illustrating a configuration example of the chip according to the first embodiment.
[FIG. 7] FIG. 7 is a plan view illustrating a configuration example of a pad.
[FIG. 8] FIG. 8 is a plan view illustrating another configuration example of the pad.
[FIG. 9] FIG. 9 is a cross-sectional view illustrating an example of a manufacturing method of the semiconductor storage device according to the first embodiment.
[FIG. 10] FIG. 10 is a cross-sectional view illustrating the manufacturing method of the semiconductor storage device in continuation from FIG. 9.
[FIG. 11] FIG. 11 is a cross-sectional view illustrating the manufacturing method of the semiconductor storage device in continuation from FIG. 10.
[FIG. 12] FIG. 12 is a cross-sectional view illustrating the manufacturing method of the semiconductor storage device in continuation from FIG. 11.
[FIG. 13] FIG. 13 is a cross-sectional view illustrating the manufacturing method of the semiconductor storage device in continuation from FIG. 12.
[FIG. 14] FIG. 14 is a cross-sectional view illustrating the manufacturing method of the semiconductor storage device in continuation from FIG. 13.
[FIG. 15] FIG. 15 s a cross-sectional view illustrating the manufacturing method of the semiconductor storage device in continuation from FIG. 14.
[FIG. 16] FIG. 16 is a cross-sectional view illustrating a configuration example of a semiconductor storage device according to a second embodiment.
[FIG. 17] FIG. 17 is a cross-sectional view illustrating an example of a manufacturing method of the semiconductor storage device according to the second embodiment.
[FIG. 18] FIG. 18 is a cross-sectional view illustrating an example of the manufacturing method of the semiconductor storage device in continuation from FIG. 17.
[FIG. 19] FIG. 19 is a cross-sectional view illustrating a configuration example of a semiconductor storage device according to a third embodiment.
[FIG. 20] FIG. 20 is a cross-sectional view illustrating a configuration example of a semiconductor storage device according to a fourth embodiment.
[FIG. 21] FIG. 21 is a plan view illustrating a configuration example of the semiconductor storage device according to the fourth embodiment.
[FIG. 22] FIG. 22 is a cross-sectional view illustrating an example of a manufacturing method according to the fourth embodiment.
[FIG. 23] FIG. 23 is a cross-sectional view illustrating the manufacturing method of the semiconductor storage device in continuation from FIG. 22.
[FIG. 24] FIG. 24 is a cross-sectional view illustrating the manufacturing method of the semiconductor storage device in continuation from FIG. 23.
[FIG. 25] FIG. 25 is a cross-sectional view illustrating a configuration example of a semiconductor storage device according to a fifth embodiment.
[FIG. 26] FIG. 26 is a cross-sectional view illustrating an example of a manufacturing method of the semiconductor storage device according to the fifth embodiment.
[FIG. 27] FIG. 27 is a cross-sectional view illustrating the manufacturing method of the semiconductor storage device in continuation from FIG. 26.
[FIG. 28] FIG. 28 is a cross-sectional view illustrating a configuration example of a semiconductor storage device according to a sixth embodiment.
[FIG. 29] FIG. 29 is an X-Y plan view illustrating a configuration of a semiconductor storage device according to a seventh embodiment.
[FIG. 30] FIG. 30 is a cross-sectional view illustrating a configuration of the semiconductor storage device according to the seventh embodiment.
[FIG. 31] FIG. 31 is a cross-sectional view illustrating an example of a manufacturing method of the semiconductor storage device according to the seventh embodiment.
[FIG. 32] FIG. 32 is a cross-sectional view illustrating the manufacturing method of the semiconductor storage device in continuation from FIG. 31.
[FIG. 33] FIG. 33 is a cross-sectional view illustrating the manufacturing method of the semiconductor storage device in continuation from FIG. 32.
[FIG. 34] FIG. 34 is a cross-sectional view illustrating the manufacturing method of the semiconductor storage device in continuation from FIG. 33.
[FIG. 35] FIG. 35 is a cross-sectional view illustrating the manufacturing method of the semiconductor storage device in continuation from FIG. 34.
[FIG. 36] FIG. 36 is a cross-sectional view illustrating the manufacturing method of the semiconductor storage device in continuation from FIG. 35.
[FIG. 37] FIG. 37 is a cross-sectional view illustrating the manufacturing method of the semiconductor storage device in continuation from FIG. 36.
[FIG. 38] FIG. 38 is a table illustrating an example of combinations of materials for a conductive layer.

### Description of Embodiments

Embodiments according to the present invention will now be explained below with reference to the drawings. The embodiments are not intended to limit the present invention. In the following embodiments, there are cases where the vertical direction of a semiconductor substrate is different from that of gravitational acceleration. The drawings are schematic or conceptual and dimensional ratios of respective parts and the like are not always the same as those of actual products. In the specification and the drawings, elements identical to those described regarding the drawings already described are denoted by like reference characters and detailed descriptions thereof are omitted as appropriate.

### (First embodiment)

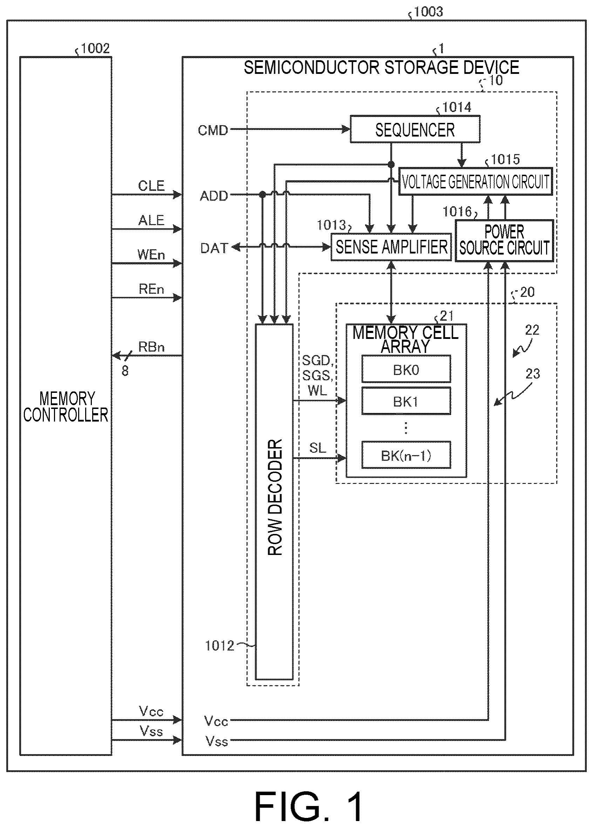

A semiconductor storage device according to a first embodiment is configured by a plurality of chips bonded to each other, and measures to appropriately connect conductive films between the chips are taken. For example, a semiconductor storage device 1 is configured as illustrated in FIG. 1.

FIG. 1 is a block diagram illustrating a configuration of the semiconductor storage device 1. The semiconductor storage device 1 includes a plurality of chips 10 and 20. The chip 20 includes a memory cell array 21 and is also called a memory chip. The chip 10 includes a circuit for controlling the memory cell array 21 and is also called a circuit chip.

Although FIG. 1 illustrates a configuration example in which the semiconductor storage device 1 includes one chip (memory chip) 20, the semiconductor storage device 1 may include two or more memory chips.

The semiconductor storage device 1 may be a non-volatile memory storing data therein in a non-volatile manner and can be applied to a memory system 1003 such as a memory card and an SSD (Solid State Drive). The memory system 1003 includes the semiconductor storage device 1 and a memory controller 1002.

The semiconductor storage device 1 receives a power Vss, a power Vcc, a command latch enable signal CLE, an address latch enable signal ALE, a write enable signal WEn, and a read enable signal REn from the memory controller 1002, for example. The semiconductor storage device 1 transmits a ready-busy signal RBn. Further, the semiconductor storage device 1 transmits and receives an input/output signal I/O. With these signals and the like, the semiconductor storage device 1 is controlled by the memory controller 1002.

The input/output signal I/O can include a command CMD, address information ADD, and a data signal DAT. The power Vss has a reference potential (for example, a ground potential). The power Vcc has a predetermined potential (for example, a power-source potential). The command latch enable signal CLE indicates that the input/output signal I/O is the command CMD. The address latch enable signal ALE indicates that the output signal I/O is the address information ADD. The write enable signal WEn can be used when a write operation is enabled. The read enable signal REn can be used when a read operation is enabled. The ready-busy signal RBn indicates that the semiconductor storage device 1 is in a ready state or a busy state.

The chip 20 includes power lines 22 and 23. The power Vss is transmitted to the chip 10 via the power line 22. The power Vcc is transmitted to the chip 10 via the power line 23.

The chip 20 further includes the memory cell array 21. In the memory cell array 21, a plurality of memory cell transistors (hereinafter, simply "memory cells") are arranged three-dimensionally. Each memory cell array 21 includes a plurality of blocks BK.

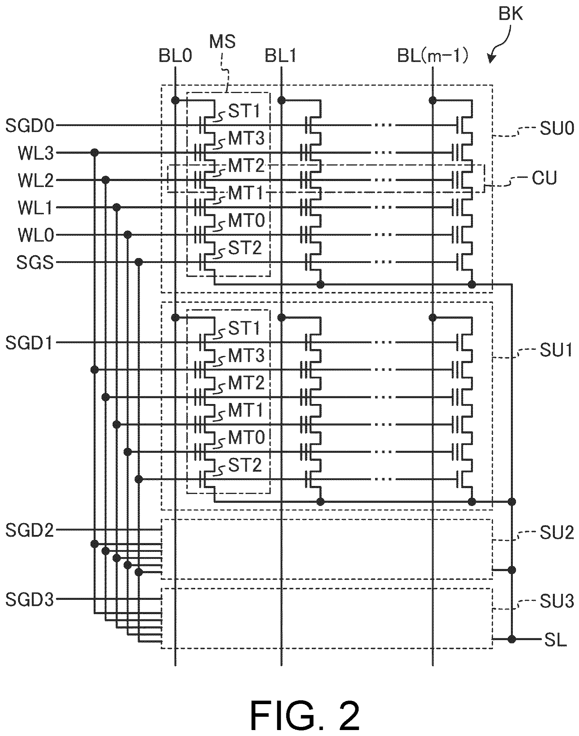

FIG. 2 is a circuit diagram illustrating a configuration of the block BK. Each block BK includes a plurality of memory cell transistors (hereinafter, "memory cells") MT to which a word line WL is connected in common.

The block BK includes four string units SU0 to SU3, for example. Each string unit SU includes a plurality of memory strings MS. The memory strings MS respectively correspond to a plurality of bit lines BL0 to BL(m-1) (m is any integer of 2 or more). The memory string MS is connected to the corresponding bit line BL. Each memory string MS includes memory cells MT0 to MT3 and selection transistors ST1 and ST2.

In each memory string MS, a drain of the selection transistor ST1 is connected to the bit line BL. The memory cell transistors MT0 to MT3 are connected in series between a source of the selection transistor ST1 and a drain of the selection transistor ST2. A source of the selection transistor ST2 is connected to a source line SL.

Gates of the selection transistors ST1 in the respective memory strings MS included in the string unit SU are connected to a selection gate line SGD in common. Gates of the selection transistors ST2 in the respective memory strings MS included in the block BK are connected to a selection gate line SGS in common. Gates of the memory cell transistors MT in the respective memory strings MS included in the block BK are connected to the word line WL in common.

In one string unit SU, a set of the memory cells MT connected to one word line WL is referred to as a cell unit CU. For example, in a case where the memory cell MT stores p-bit data (p is an integer of 1 or more) therein, the storage capacity of the cell unit CU is defined as p-page data.

Each bit line BL is connected to the drains of the selection transistors ST1 of the corresponding memory strings MS in the respective string units SU of the block BK, and is shared by the memory strings MS of the block BK. The source line SL is connected to the sources of the selection transistors ST2 of the respective memory strings MS included in the block BK in common, and is shared by the string units SU of the block BK. The source line SL may be shared by the blocks BLK.

The chip 10 (circuit chip) illustrated in FIG. 1 includes a row decoder 1012, a sense amplifier 1013, a sequencer 1014, a voltage generation circuit 1015, and a power source circuit 1016.

The power source circuit 1016 supplies the powers Vss and Vcc received via the power lines 22 and 23 to each component. For example, the power source circuit 1016 supplies the powers Vss and Vcc to the voltage generation circuit 1015.

The sequencer 1014 executes overall control of each component. For example, the sequencer 1014 controls a write operation in accordance with a write command that is one of the commands CMD. In control of the write operation, the sequencer 1014 writes data corresponding to the data signal DAT to the memory cell MT corresponding to the address information ADD in the memory cell array 21. Further, the sequencer 1014 transmits a write completion notification to the memory controller 1002. The sequencer 1014 controls a read operation in accordance with a read command that is one of the commands CMD. In control of the read operation, the sequencer 1014 reads data from the memory cell MT whose address is specified in the memory cell array 21 and sends back the data signal DAT in accordance with the read data to the memory controller 1002.

The voltage generation circuit 1015 generates a voltage in accordance with the control by the sequencer 1014 by using the powers Vss and Vcc and supplies the voltage to the row decoder 1012 and the sense amplifier 1013.

The row decoder 1012 decodes the address information ADD, selects the word line WL corresponding to a memory cell in the memory cell array 21, to which a write operation or a read operation is to be performed, in accordance with the decoding result, and supplies the voltage to the word line WL selected in this manner.

The sense amplifier 1013 decodes the address information ADD and selects the bit line BL corresponding to the memory cell in the memory cell array 21, to which the write operation or the read operation is to be performed, in accordance with the decoding result. The sense amplifier 1013 supplies the voltage to the bit line BL selected in the write process. In the read process, the sense amplifier 1013 supplies the voltage to the selected bit line BL and senses the potential of the selected bit line BL.

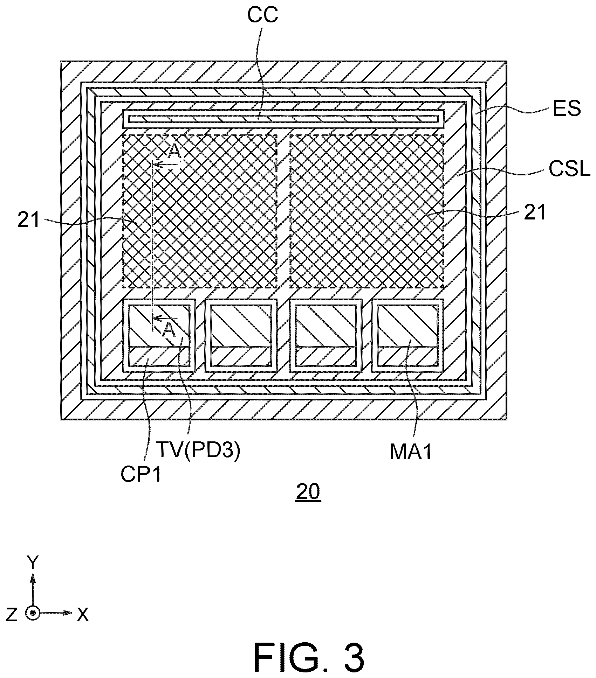

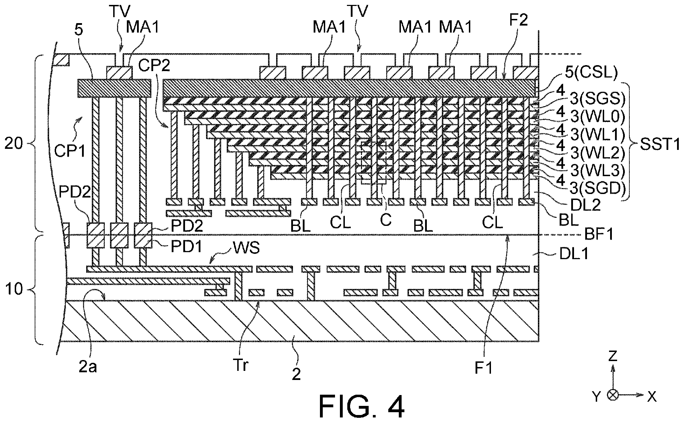

The power lines 22 and 23 illustrated in FIG. 1 can be realized by wires MA1 illustrated in FIGS. 3 and 4, for example. In the following description, a direction perpendicular to the surface of a substrate 2 is defined as a Z-direction, and two directions perpendicular to each other in a plane perpendicular to the Z-direction are defined as an X-direction and a Y-direction.

FIG. 3 is an X-Y plan view illustrating a configuration of the semiconductor storage device 1. FIG. 4 is an X-Z cross-sectional view illustrating the configuration of the semiconductor storage device 1. FIG. 4 illustrates a cross-section when FIG. 3 is cut along a line A-A as an example. The semiconductor storage device 1 has a substantially rectangular shape in plan view along the X-Y plane, in which the X-direction is assumed as the longitudinal direction, for example. The semiconductor storage device 1 can include the chip 10 and the chip 20 stacked on the chip 10.

In a planar layout, as illustrated in FIG. 3, the memory cell arrays 21 are provided in a center portion of the chip 20, a contact plug CC is provided on one side of the memory cell arrays 21, and a pad PD3 exposed through an opening TV is provided on the opposite side of the memory cell arrays 21. The pad PD3 is the wire MA1 exposed through the opening TV. A contact plug CP1 is arranged under the pad PD3 and, in plan view as viewed from the Z-direction, is overlapped by the pad PD3. An edge seal ES is provided to surround the memory cell arrays 21, the pad PD3, and the contact plugs CP1 and CC. The contact plug CC is used for transmitting a power, a signal, and the like and is connected to any element of the chip 10. The edge seal ES is provided in order to prevent crack or separation due to external factors.

As illustrated in FIG. 4, in the memory cell arrays 21 in the chip 20, a plurality of stacks SST1 are arranged, respectively. The stacks SST1 may be arranged two-dimensionally in the X- and Y-directions. Each stack SST1 has a substantially rectangular shape in plan view along the X-Y plane. Each stack SST1 functions as a portion of the memory cell array 21. The wires MA1 are arranged on the +Z-side of the stack SST1. Each wire MA1 is mostly covered with an insulation film DL2, but is partly exposed near its -Y-side end via the opening TV. Accordingly, each wire MA1 allows a wire BW described later in wire bonding to be bonded thereto via the opening TV.

In the chip 20, the wire MA1 is also provided above a contact plug (CP1 in FIG. 4) electrically connected to the chip 10. The wire MA1 above the contact plug CP1 is provided in an island shape to correspond to a region above the contact plug CP1 in plan view as viewed from the Z-direction. The opening TV is also provided in the insulation film DL2 on the wire MA1 above the contact plug CP1. The wire MA1 above the contact plug CP1 is also partly exposed from the insulation film DL2 through the opening TV. The wire MA1 above the contact plug CP1 also allows a wire (not illustrated) in wire bonding, for example, to be bonded thereto via the opening TV.

The wire MA1 above the contact plug CP1 is provided to correspond to the arrangement of the contact plug CP1 in the chip 20. For example, in FIG. 3, two wires MA1 are provided in each of two corners of the surface of the chip 20. However, the number and the position of the wires MA1 above the contact plug CP1 are not limited thereto.

The edge seal ES is provided as a structure shared by the chips 10 and 20. The edge seal ES surrounds the stack SST1 from outside in the X- and Y-directions as viewed in the Z-direction. Accordingly, the edge seal ES protects the memory cell arrays 21 and the circuit for controlling them (for example, the row decoder 1012, the sense amplifier 1013, the sequencer 1014, the voltage generation circuit 1015, and the power source circuit 1016) from external electrostatic noise, crack, and separation.

For simplicity, the illustration of the configuration of the edge seal ES is omitted as appropriate.

The chip 20 is arranged on the +Z-side of the chip 10. That is, the chip 20 is bonded to the +Z-side surface of the chip 10. The chip 20 has a surface F1 and a surface F2 opposite the surface F1. The chip 20 is bonded to the chip 10 on the surface F1 side. The wire MA1 and the opening TV illustrated in FIG. 3 are provided on the surface F2 side of the chip 20.

The chip 10 includes an insulation film (film containing silicon and oxygen, for example) DL1 and an electrode PD1 on the +Z-side. The chip 20 includes the insulation film (film containing silicon and oxygen, for example) DL2 and an electrode PD2 on the -Z-side. At a bonding surface BF1 between the chips 10 and 20, the insulation film DL1 of the chip 10 and the insulation film DL2 of the chip 20 are bonded to each other, and the electrode PD1 of the chip 10 and the electrode PD2 of the chip 20 are bonded to each other.

The chip 10 includes the substrate 2, a transistor Tr, the electrode PD1, a wiring structure WS, and the insulation film DL1. The substrate 2 is arranged in the -Z-side portion of the chip 10 and extends in the X- and Y-directions like a plate. The substrate 2 may be a semiconductor substrate and can be made of a material mainly containing semiconductor (for example, silicon). The substrate 2 has a +Z-side surface 2a. The transistor Tr functions as a circuit element of the circuit for controlling the memory cell arrays 21 (for example, the row decoder 1012, the sense amplifier 1013, the sequencer 1014, the voltage generation circuit 1015, and the power source circuit 1016). The transistor Tr includes a conductive gate electrode arranged on the surface 2a of the substrate 2 via a gate dielectric film and source and drain electrodes arranged near the surface 2a in the substrate 2 as semiconductor regions. The electrode PD1 is arranged in such a manner that the surface thereof is exposed in the bonding surface BF1 between the chips 10 and 20. The wiring structure WS extends mainly in the Z-direction and connects the gate electrode and the source and drain electrodes of the transistor Tr, for example, to the electrodes PD1.

The chip 20 includes the stack SST1, a conductive layer 5, a plurality of columnar bodies CL, a plurality of contact plugs CP2, the contact plugs CP1, the bit lines BL, the wires MA1, the electrode PD2, and the insulation film DL2. In the stack SST1, a plurality of conductive layers 3 are stacked in the Z-direction via a conductive layer 4. The conductive layers 3 function as the selection gate line SGD, a word line WL3, a word line WL2, a word line WL1, a word line WL0, and the selection gate line SGS from the -Z-side to the +Z-side in this order.

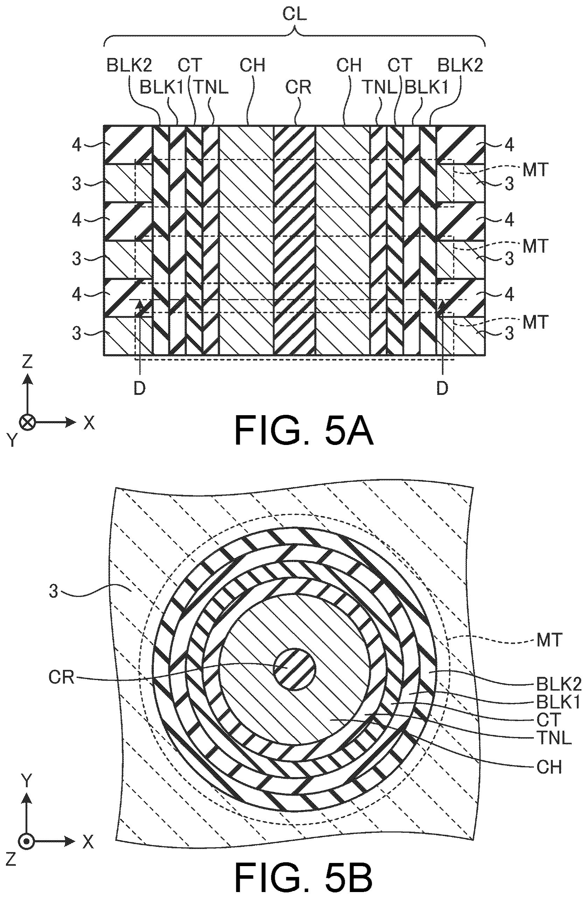

Each conductive layer 3 extends in the X- and Y-directions like a plate. Each columnar body CL extends in the Z-direction through the conductive layers 3. Each columnar body CL may penetrate through the stack SST1 in the Z-direction. Each columnar body CL extends in the Z-direction to be columnar. Each columnar body CL includes a semiconductor film CH (see FIG. 5) functioning as a channel region. The semiconductor film CH extends like a column having an axis along the Z-direction (in a columnar shape or a cylindrical shape, for example). A plurality of crossing positions at which the conductive layers 3 and the columnar bodies CL cross each other, that is, a plurality of crossing positions at which the conductive layers 3 and the semiconductor films CH cross each other function as the memory cells MT.

FIG. 5(a) is an X-Z cross-sectional view illustrating a configuration of the memory cell MT and is an enlarged cross-sectional view of a portion C in FIG. 4. FIG. 5(b) is an X-Y cross-sectional view illustrating the configuration of the memory cell MT and illustrates a cross-section when FIG. 5(a) is cut along a line D-D. As illustrated in FIG. 5(a) and FIG. 5(b), each columnar body CL includes an insulation film CR, the semiconductor film CH, an insulation film TNL, a charge storage film CT, an insulation film BLK1, and an insulation film BLK2. The insulation film CR extends in the Z-direction and forms a columnar shape having an axis along the Z-direction. The insulation film CR is made of an insulator containing silicon and oxygen. The semiconductor film CH extends in the Z-direction to cover the insulation film CR from outside in the X- and Y-directions and forms a cylindrical shape having an axis along the Z-direction. The semiconductor film CH can be made of semiconductor containing polysilicon. The insulation film TNL extends in the Z-direction to cover the semiconductor film CH from outside in the X- and Y-directions and forms a cylindrical shape having an axis along the Z-direction. The insulation film TNL can be made of an insulator containing silicon and oxygen. The charge storage film CT extends in the Z-direction to cover the insulation film TNL from outside in the X- and Y-directions and forms a cylindrical shape having an axis along the Z-direction. The charge storage film CT can be made of an insulator containing silicon and nitrogen. The insulation film BLK1 extends in the Z-direction to cover the charge storage film CT from outside in the X- and Y-directions and forms a cylindrical shape having an axis along the Z-direction. The insulation film BLK1 can be made of an insulator containing silicon and oxygen. The insulation film BLK2 extends in the Z-direction to cover the insulation film BLK1 from outside in the X- and Y-directions and forms a cylindrical shape having an axis along the Z-direction. The insulation film BLK2 can be made of an insulator containing aluminum and oxygen. A portion surrounded by a dotted line in FIG. 5(a) and FIG. 5(b) functions as the memory cell MT.

The tip of the semiconductor film CH in the columnar body CL reaches the conductive layer 5 as illustrated in FIG. 4. The semiconductor film CH is connected to the conductive layer 5 at its +Z-side end and to the bit line BL via a plug at its -Z-side end. The conductive layer 5 can be made of semiconductor (for example, polysilicon) with conductivity provided thereto. The conductive layer 5 functions as a cell source CSL in the source line SL. The semiconductor film CH functions as a channel region in the memory string MS.

The conductive layers 3 may have the same width in the Y-direction as each other. The conductive layers 3 have widths in the X-direction in such a manner that those widths increase stepwise from the -Z-side to the +Z-side. The ends in the X-direction of the respective conductive layers 3 are gradually shifted to outside from the -Z-side to the +Z-side. Accordingly, a staircase structure is configured in a plug connecting portion in the memory cell array 21, in which the selection gate line SGD, the word lines WL, and the selection gate line SGS are drawn out like stairs in turn from the -Z-side to the +Z-side in this order.

The contact plugs CP2 correspond to the conductive layers 3. Each contact plug CP2 is arranged between the electrode PD2 and the corresponding conductive layer 3 in the Z-direction, is electrically connected to the electrode PD2 at its -Z-side end, extends in the Z-direction, and is electrically connected to the corresponding conductive layer 3 at its +Z-side end. Accordingly, the contact plug CP2 electrically connects the electrode PD2 and the corresponding conductive layer 3 to each other.

The contact plugs CP1 extend in the Z-direction between the surface F1 and the surface F2 and are apart from the stack SST1 constituting the memory cell array. The contact plugs CP1 correspond to the electrodes PD2, respectively, and are connected between the electrodes PD2 and the conductive layer 5. That is, each contact plug CP1 is electrically connected to the electrode PD2 at its -Z-side end and to the conductive layer 5 at its +Z-side end. The electrode PD2 is connected to PD1 of the chip 10 via the bonding surface BF1 and is further electrically connected to the substrate 2 of the chip 10 or any transistor. The conductive layer 5 is connected to the wire MA1 on the surface F2 side of the chip 20 and is electrically connected to a wire (not illustrated) bonded via the opening TV. Accordingly, an external device can supply a power, input a command, and receive data to/from a circuit (for example, a CMOS (Complementary Metal Oxide Semiconductor) circuit) of the chip 10 via the wire, the contact plug CP1, and the like.

The bit lines BL are arranged on the -Z-side of the stack SST1. The bit lines BL are arranged in the X-direction. Each bit line BL extends in the Y-direction. The bit lines BL correspond to the columnar bodies CL, respectively. Each bit line BL is electrically connected to the -Z-side end of the corresponding columnar body CL. The bit line BL is electrically connected to the electrode PD2. Accordingly, the bit line BL can be connected to the transistor Tr of the chip 10 via the electrode PD2, the electrode PD1, and the wiring structure WS.

The wires MA1 are arranged on the +Z-side of the stack SST1. The wires MA1 on the stack SST1 are arranged in the X-direction. Each wire MA1 on the stack SST1 extends in the Y-direction. Each wire MA1 extends in the Y-direction across the stack SST1 as viewed in the Z-direction. Each wire MA1 functions as the power line 22 or 23, and its width and thickness can be determined in accordance with the amount of power to be transmitted and the extending length.

The wire MA1 is also provided above the surface F2 side end of the contact plug CP1. In plan view as viewed from the Z-direction, the wire MA1 above the contact plug CP1 overlaps the contact plug CP1 and covers the surface F2 side end of the contact plug CP1.

A low-resistance metal material such as aluminum is used for the wire MA1.

The conductive layer 5 is arranged on the surface F2 side of the chip 20 and is arranged on the +Z-side of the stack SST1. The conductive layer 5 on the stack SST1 is provided in common to the columnar bodies CL of the stack SST1 and the wires MA1 and spreads in the X-Y plane to correspond to the stack SST1. The conductive layer 5 is provided between the stack SST1 and the wire MA1 and electrically connects the stack SST1 and the wire MA1 to each other. The conductive layer 5 functions as the cell source CSL and can supply a source voltage to each columnar body CL.

The conductive layer 5 is also provided on the surface F2 side end of the contact plug CP1. In plan view as viewed from the Z-direction, the conductive layer 5 on the contact plug CP1 overlaps the contact plug CP1, is overlapped by the wire MA1, and is provided between the surface F2 side end of the contact plug CP1 and the wire MA1.

A conductive material, for example, monocrystalline semiconductor doped with N-type impurities (for example, phosphorus or arsenic), polysilicon, titanium, titanium nitride, or tungsten is used for the conductive layer 5. As the semiconductor material used for the conductive layer 5, silicon can be used, for example.

The electrode PD2 is arranged to be exposed in the bonding surface BF1 between the chips 10 and 20. Accordingly, the electrode PD2 is bonded to the electrode PD1 of the chip 10 at the bonding surface BF1.

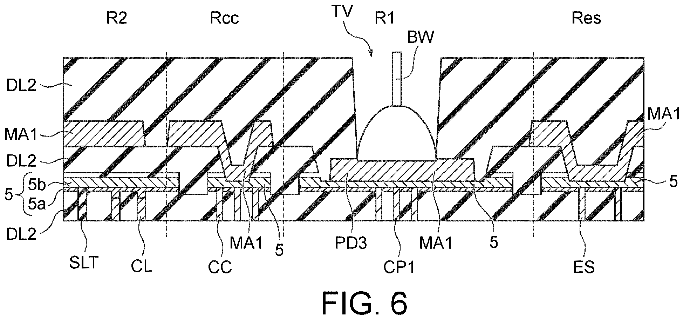

FIG. 6 is a cross-sectional view illustrating a configuration example of the chip 20 according to the first embodiment. FIG. 6 illustrates a region R1 of the memory cell array 21, a region Rcc of the contact plug CC, a region R1 of the contact plug CP1, and a region Res of the edge seal ES side by side.

The wire MA1 and the conductive layer 5 are provided on each of the memory cell array 21, the pad PD3, the contact plugs CP1 and CC, and the edge seal ES. The wires MA1 on the memory cell array 21, the pad PD3, the contact plug CP1, and the edge seal ES are electrically isolated from one another. The conductive layers 5 on the memory cell array 21, the pad PD3, the contact plug CP1, and the edge seal ES are also electrically isolated from one another. Although the edge seal ES may be in an electrically floating state, it may be connected to the power line 22 in order to avoid static electricity.

The conductive layer 5 and the wire MA1 provided in the region R2 of the memory cell array 21 are electrically connected to each other and function as the cell source CSL. The conductive layer 5 and the wire MA1 provided in the region Rcc of the contact plug CC are electrically connected to each other and function as a wire connected to the contact plug CC. The conductive layer 5 and the wire MA1 provided in the region R1 of the contact plug CP1 are electrically connected to each other and function as the pad PD3 connected to the contact plug CP1. The wire BW is bonded onto the pad PD3. The conductive layer 5 and the wire MA1 provided in the region Res of the edge seal ES are electrically connected to each other and function as a wire connected to the edge seal ES. In the second embodiment, the conductive layer 5 is configured as a stack of conductive layers 5a and 5b.

A metal material such as aluminum is used for the wire MA1. A conductive material, for example, monocrystalline semiconductor, polysilicon, titanium, titanium nitride, or tungsten is used for the conductive layer 5. For example, doped polysilicon is used for the conductive layer 5a, and a stacked film of titanium, titanium nitride, and tungsten is used for the conductive layer 5b.

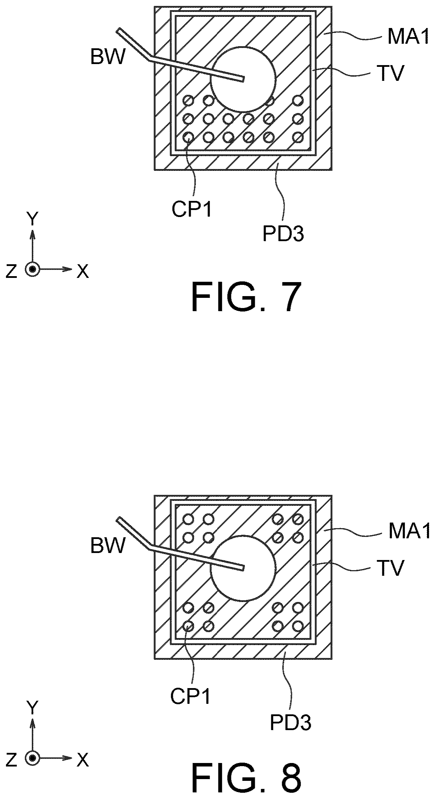

FIG. 7 is a plan view illustrating a configuration example of the pad PD3. The wire MA1 is exposed as the pad PD3 via the opening TV. The wire BW is bonded to the pad PD3.

In plan view as viewed from the Z-direction, the wire MA1 is provided in a region of the pad PD3, and the contact plug CP1 is provided under the wire MA1. That is, the contact plug CP1 is provided to be overlapped in the region of the pad PD3. Accordingly, the layout area of the chip 20 can be made small.

Further, in plan view as viewed from the Z-direction, a connecting portion of the wire BW overlaps the contact plug CP1. However, since the wire MA1 is arranged above the contact plug CP1, impact of wire bonding is reduced by the wire MA1 and the conductive layer 5. Therefore, damage to the contact plug CP1 by wire bonding can be reduced.

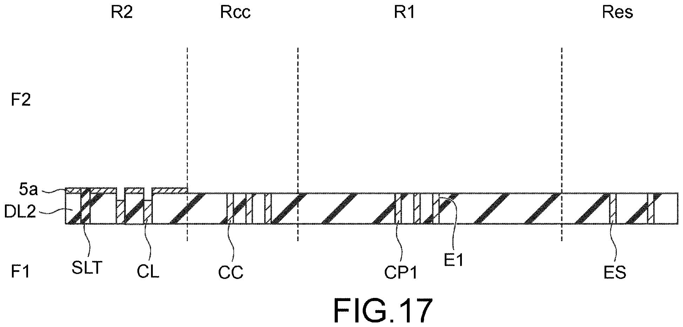

FIG. 8 is a plan view illustrating another configuration example of the pad PD3. In FIG. 17, although the contact plug CP1 is provided in the region of the pad PD3 in plan view as viewed from the Z-direction, the contact plug CP1 is not overlapped by the connecting portion of the wire BW. That is, the contact plug CP1 is not provided directly below the pad PD3, but is arranged in a corner of the pad PD3 which is located around the connecting portion of the wire BW. The wire BW is bonded to a center portion of the pad PD3 shifted from directly above the contact plug CP1. Accordingly, impact of wire bonding is not applied directly to the contact plug CP1, and therefore damage to the contact plug CP1 can be further reduced.

As described above, in the present embodiment, the conductive layer 5 is provided between the wire MA1 and the contact plug CP1, and thus protrusion of the end of the contact plug CP1 does not appear in the surface of the wire MA1 as a bonding pad. With this configuration, although the wire MA1 is provided above the contact plug CP1, the surface of the wire MA1 is substantially flat, so that a structure making wire bonding easier is obtained. Consequently, a connection failure between a wire and the contact plug CP1 can be prevented. Further, due to good flatness of the boundary between the conductive layer 5 and the wire MA1, coverage in deposition of the wire MA1 becomes good, and a highly reliable semiconductor storage device is obtained.

Next, a manufacturing method of the semiconductor storage device 1 according to the first embodiment is described.

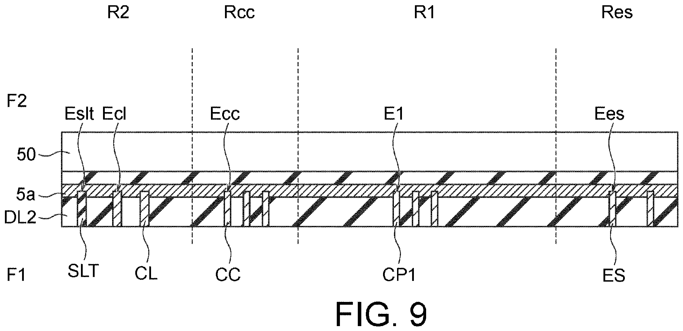

FIGS. 9 to 15 are cross-sectional views illustrating an example of the manufacturing method of the semiconductor storage device 1 according to the first embodiment.

According to the first embodiment, the conductive layer 5a (for example, doped polysilicon) is deposited on a substrate 50. The stack SST1 is formed on the surface F2 side of the conductive layer 5a. In the stack SST1, the insulation film DL2, a slit SLT, the columnar body CL, the contact plugs CP1 and CC, and the edge seal ES are illustrated, and the illustration of the rest of the configuration of the stack SST1 is omitted.

In the first embodiment, in the process of forming the stack SST1, it is necessary to etch the stack SST1 in order to form grooves or holes for forming the slit SLT, the columnar body CL, the contact plugs CP1 and CC, and the edge seal ES. The grooves or holes for forming the slit SLT, the columnar body CL, the contact plugs CP1 and CC, and the edge seal ES are formed by using the conductive layer 5a as an etching stopper. Accordingly, ends Eslt, Ecl, E1, Ecc, and Ees (hereinafter, also "ends E1 and the like" collectively) of the slit SLT, the columnar body CL, the contact plugs CP1 and CC, and the edge seal ES protrude into the conductive layer 5a.

The chip 20 formed in this manner is bonded to the chip 20. FIG. 9 illustrates the surface F2 side portion of the chip 20 bonded to the chip 10.

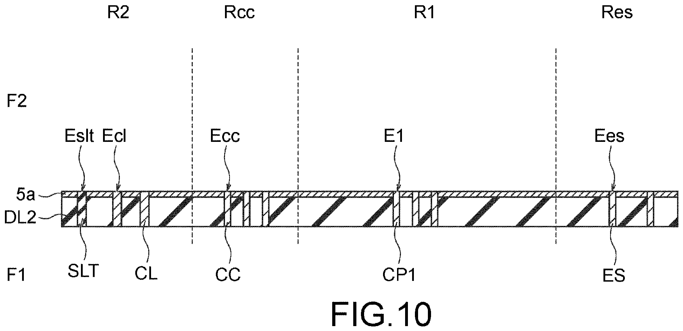

Next, as illustrated in FIG. 10, the substrate 50 is removed by CMP, and the conductive layer 5a is etched back. The ends E1 and the like of the contact plugs CP1 and CC, the columnar body CL, and the edge seal ES are thus exposed.

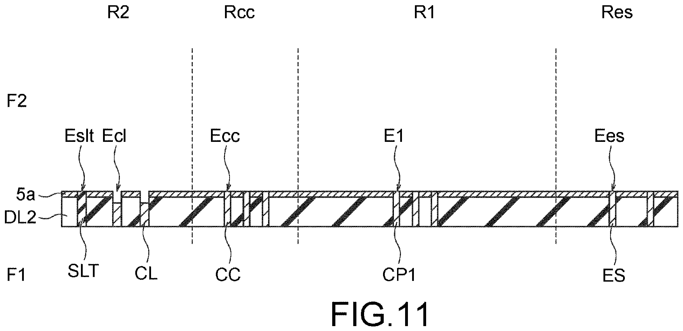

Next, as illustrated in FIG. 11, the end Ecl of the columnar body CL is slightly etched back. At this time, it is preferable to etch back the insulation film CR in FIG. 5 in the columnar body CL to expose the side surface of the semiconductor film CH.

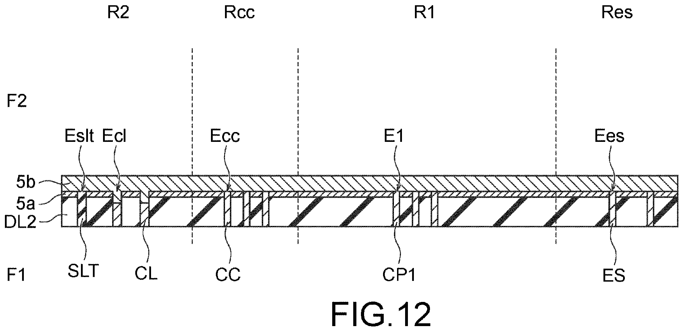

Next, as illustrated in FIG. 12, the conductive layer 5b is formed on the conductive layer 5a. As the conductive layer 5b, a tungsten film including a stacked film of titanium and titanium nitride as a barrier metal can be used, for example. In this case, the conductive layer 5b is a stacked film (Ti/TiN/W) of titanium (Ti), titanium nitride (TiN), and tungsten (W). The conductive layer 5b is electrically connected to the end E1 of the contact plug CP1, the end Ecc of the contact plug CC, the end Ecl of the columnar body CL, the end Ees of the edge seal ES, and the like. In the columnar body CL, the conductive layer 5b can be connected to the side surface of the semiconductor film CH, which is exposed by etching back the insulation film CR, and the end Ecl securely.

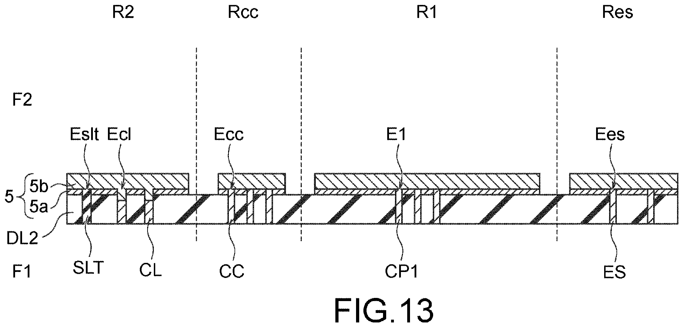

Next, as illustrated in FIG. 13, the conductive layers 5a and 5b (hereinafter, also "the conductive layer 5") are processed by lithography and etching. Accordingly, the conductive layers 5 in the region R2, Rcc, R1, and Res are electrically isolated from one another.

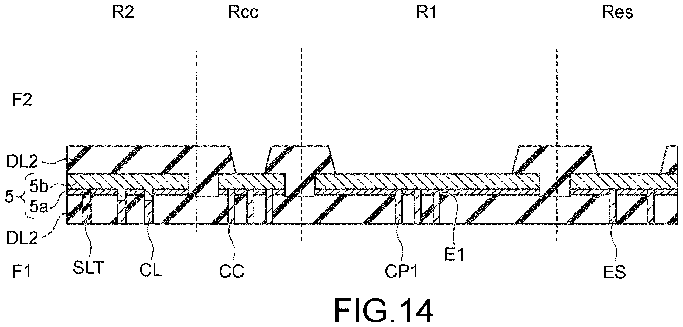

Next, as illustrated in FIG. 14, the material for the insulation film DL2 is formed on the conductive layer 5. The insulation film DL2 is embedded between the conductive layers 5 in the regions R2, Rcc, R1, and Res and electrically insulates them. An insulation material, for example, containing silicon and oxygen is used for the insulation film DL2. Next, the insulation film DL2 on the conductive layer 5 is processed by lithography and etching. Accordingly, the portions of the conductive layer 5 above the contact plugs CC and CP1 and the edge seal ES are exposed.

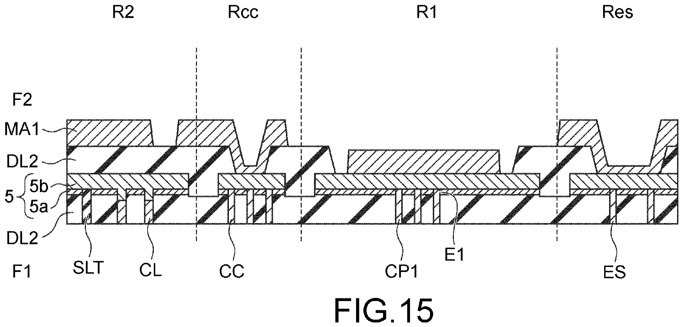

Next, as illustrated in FIG. 15, the material for the wire MA1 is formed on the insulation film DL2 and the conductive layer 5. As for the wire MA1, a metal material such as aluminum can be deposited by sputtering, for example. The material for the wire MA1 is formed on the portions of the conductive layer 5 above the contact plugs CC and CP1 and the edge seal ES. Next, the material for the wire MA1 is processed by lithography and etching. Accordingly, the wires MA1 above the contact plugs CC and CP1 and the edge seal ES are electrically isolated from one another.

Thereafter, the material for the insulation film DL2 is further formed on the wire MA1, and the opening TV is formed by removing the insulation film DL2 on the contact plug CP1 by lithography and etching. The pad PD3 illustrated in FIG. 6 is formed in this manner. By bonding the wire BW to the pad PD3, the semiconductor storage device 1 illustrated in FIG. 6 is completed.

According to the first embodiment, the conductive layer 5 covers the ends E1 of the contact plugs CC and CP1, the slit SLT, and the edge seal ES. The conductive layer 5b as the upper portion of the conductive layer 5 is not significantly etched even when the insulation film DL2 containing silicon and oxygen is processed, because the conductive layer 5b contains a metal material such as tungsten. Therefore, the surface of the conductive layer 5 on the surface F2 side can be kept substantially flat. Accordingly, the wire MA1 on the conductive layer 5 also becomes substantially flat, so that it is possible to easily form a bonding pad directly above the contact plug CP1. Consequently, as illustrated in FIGS. 7 and 8, the contact plug CP1 can be overlapped in the region of the pad PD3 in plan view as viewed from the Z-direction. This configuration leads to downscaling of the semiconductor storage device 1.

Further, in the first embodiment, although the conductive layers 5 in the regions R2, Rcc, R1, and Res are electrically isolated from one another, the conductive layers 5 are formed by the same process in the same layer from the same material (for example, tungsten). Similarly, although the wires MA1 in the regions R2, Rcc, R1, and Res are electrically isolated from each other, the wires MA1 are formed by the same process in the same layer from the same material (for example, aluminum). Accordingly, it is unnecessary to form the conductive layer 5 and the wire MA1 separately in the regions R2, Rcc, R1, and Res, and therefore a manufacturing process can be shortened.

### (Second embodiment)

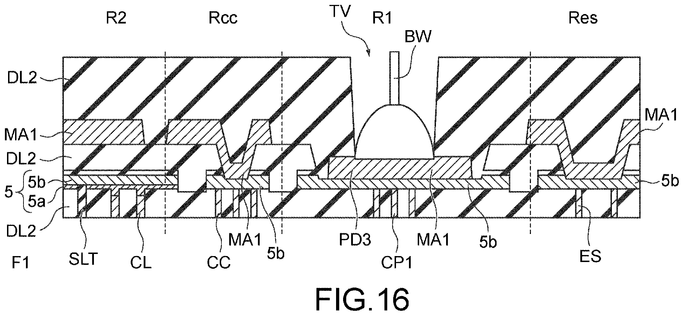

FIG. 16 is a cross-sectional view illustrating a configuration example of the semiconductor storage device 1 according to a second embodiment. In the second embodiment, the conductive layer 5a is provided only in the region R2 of the memory cell array 21 and is not provided in the regions Rcc, R1, and Res of the contact plugs CC and CP1 and the edge seal ES. The rest of the configuration of the second embodiment may be identical to that of the first embodiment.

Even in a case where the conductive layer 5a is not provided in the regions Rcc, R1, and Res, the second embodiment can obtain effects identical to those of the first embodiment as long as the conductive layer 5b is formed to be substantially flat.

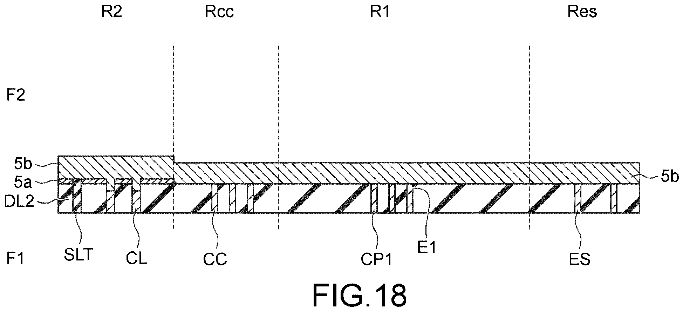

FIGS. 17 and 18 are cross-sectional views illustrating an example of a manufacturing method of the semiconductor storage device 1 according to the second embodiment. After the processes described with reference to FIGS. 9 to 11, the conductive layer 5a is processed by lithography and etching as illustrated in FIG. 17. With this process, the conductive layers 5a in the regions Rcc, R1, and Res are removed, so that the conductive layer 5a is left only in the region R2 of the memory cell array 21.

Next, as illustrated in FIG. 18, the conductive layer 5b is formed on the conductive layer 5a, the contact plugs CC and CP1, and the edge seal ES.

Thereafter, after the processes described with reference to FIGS. 13 to 15, the semiconductor storage device 1 illustrated in FIG. 16 is completed.

According to the second embodiment, the conductive layer 5 in the region R2 of the memory cell array 21 is formed by a stacked film of the conductive layers 5a and 5b, and the conductive layers 5 in the other regions Rcc, R1, and Res are each formed by the conductive layer 5b. As described above, the material for the conductive layer 5 may be different between the region R2 of the memory cell array 21 and the other regions Rcc, R1, and Res.

### (Third embodiment)

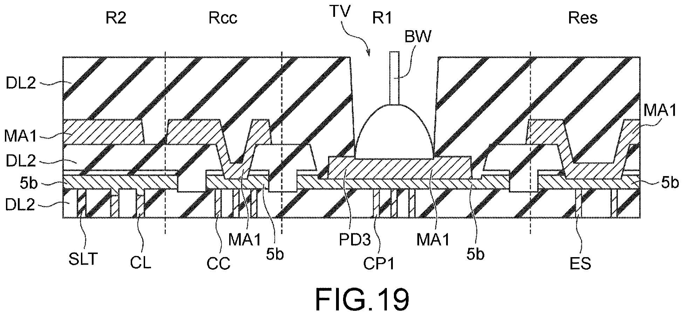

FIG. 19 is a cross-sectional view illustrating a configuration example of the semiconductor storage device 1 according to a third embodiment. In the third embodiment, the conductive layer 5a using polysilicon, for example, is not provided, and the conductive layer 5b using a metal material such as tungsten is provided in the regions R2, Rcc, R1, and Res. Although the conductive layers 5b in the regions R2, Rcc, R1, and Res are electrically isolated from one another, they are formed by the same process in the same layer from the same material. A stacked film (Ti/TiN/W) of titanium (Ti), titanium nitride (TiN), and tungsten (W) is used for the conductive layer 5b, for example. The conductive layer 5b provided in the region R1 is in contact with the contact plug CP1. The conductive layer 5b provided in the region Rcc is in contact with the contact plug CC. The conductive layer 5b provided in the region R2 is in contact with the columnar body CL. The conductive layer 5b provided in the region Res is in contact with the edge seal ES. The rest of the configuration of a fourth embodiment may be identical to that of the third embodiment.

Even in a case where the conductive layer 5a is not provided, the third embodiment can obtain effects identical to those of the second embodiment as long as the conductive layer 5b is formed to be substantially flat.

A manufacturing method according to the third embodiment can be understood easily from the manufacturing method according to the second embodiment, and therefore the illustrations thereof are omitted. For example, the conductive layer 5a functions as an etching stopper in the process of forming the contact plugs CP1 and CC and the like and is then removed in all the regions R2, Rcc, R1, and Res in the process illustrated in FIG. 17. Thereafter, after the process described with reference to FIG. 18, the semiconductor storage device 1 illustrated in FIG. 19 is completed.

### (Fourth embodiment)

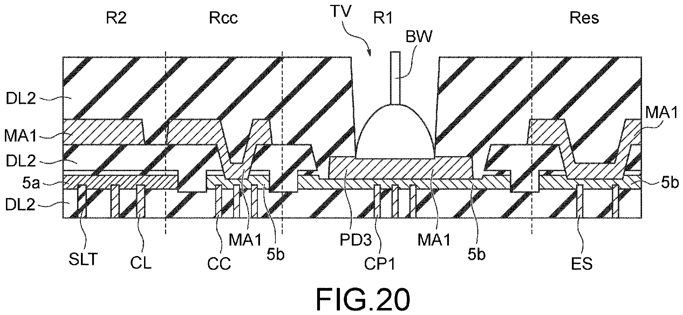

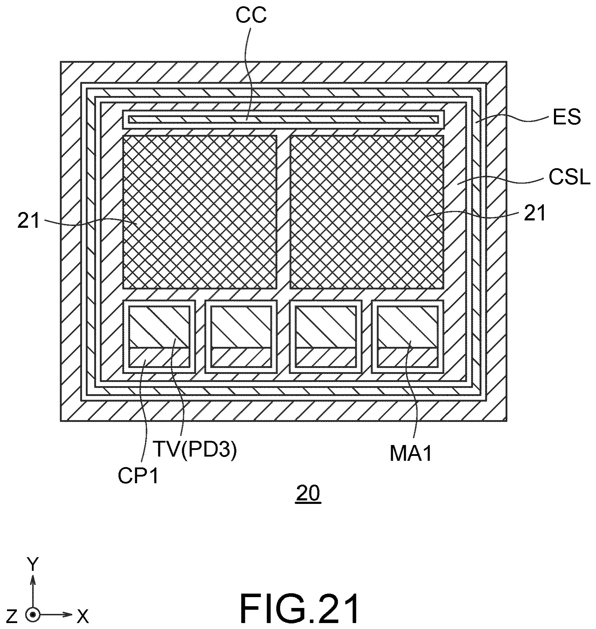

FIG. 20 is a cross-sectional view illustrating a configuration example of the semiconductor storage device 1 according to a fourth embodiment. FIG. 21 is a plan view illustrating the configuration example of the semiconductor storage device 1 according to the fourth embodiment.

In the fourth embodiment, in the region R2 of the memory cell array 21, the conductive layer 5a using polysilicon, for example, is provided, whereas the conductive layer 5b using a metal material is not provided. Meanwhile, in the region Rcc of the contact plug CC, the region R2 of the contact plug CP1 and the pad PD3, and the region Res of the edge seal ES, the conductive layer 5b using a metal material such as tungsten, for example, is provided, and the conductive layer 5a is not provided. The conductive layer 5a in the region R2 is electrically isolated from the conductive layers 5b in the region Rcc, R1, and Res. The conductive layer 5b provided in the region R1 is in contact with the contact plug CP1. The conductive layer 5b provided in the region Rcc is in contact with the contact plug CC. The conductive layer 5a provided in the region R2 is in contact with the columnar body CL. The conductive layer 5b provided in the region Res is in contact with the edge seal ES. The rest of the configuration of the fourth embodiment may be identical to that of the third embodiment.

Even in a case where the different conductive layers 5a and 5b are provided in the region R2 of the memory cell array 21 and in the regions Rcc, R2, and Res, the fourth embodiment can obtain effects identical to those of the third embodiment as long as the conductive layer 5b is formed to be substantially flat.

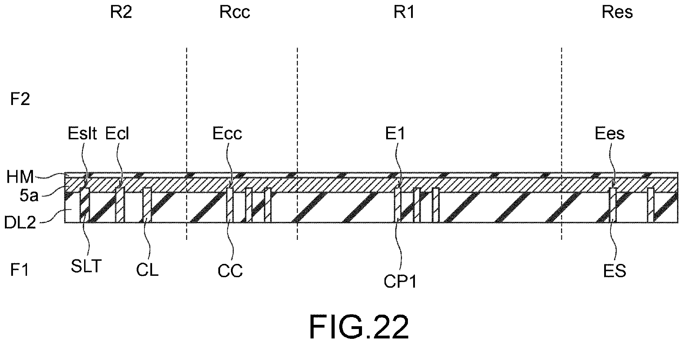

FIGS. 22 to 24 are cross-sectional views illustrating an example of a manufacturing method according to the fourth embodiment. After the process described with reference to FIG. 9, the substrate 50 is removed.

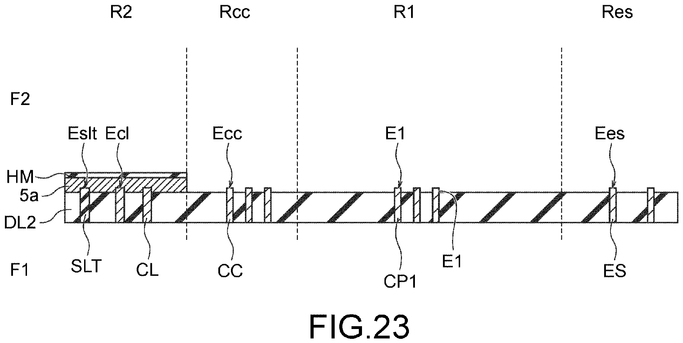

Next, as illustrated in FIG. 22, a mask material HM is formed on the conductive layer 5a. Next, by lithography and etching, the mask material HM is left in the region R2, and the mask materials HM in the other regions Rcc, R1, and Res are removed. Further, the conductive layer 5a is processed by using the mask material HM as a mask. With this process, as illustrated in FIG. 23, the conductive layers 5a in the regions Rcc, R1, and Res are removed, and the conductive layer 5a is left in the region R2 of the memory cell array 21. In this process, the ends Ecc, E1, and Ees of the contact plugs CC and CP1 and the edge seal ES may protrude from the insulation film DL2.

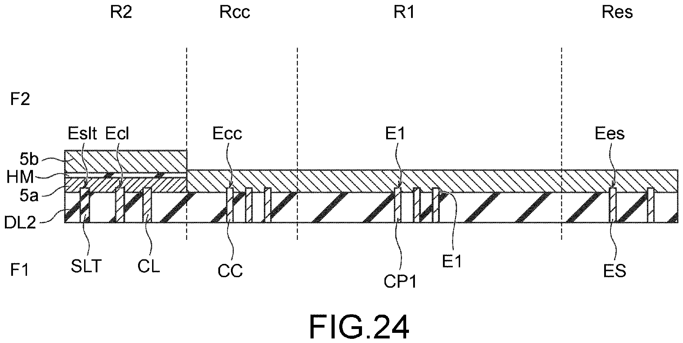

Next, as illustrated in FIG. 24, the material for the conductive layer 5b is deposited in the regions R2, Rcc, R1, and Res. With this process, in the regions Rcc, R1, and Res, the ends Ecc, E1, and Ees of the contact plugs CC and CP1 and the edge seal ES are covered with the conductive layer 5b and are embedded therein. Accordingly, the surface of the conductive layer 5b on the surface F2 side is substantially flat.

Thereafter, after the processes described with reference to FIGS. 13 to 15, the semiconductor storage device 1 illustrated in FIG. 20 is completed.

### (Fifth embodiment)

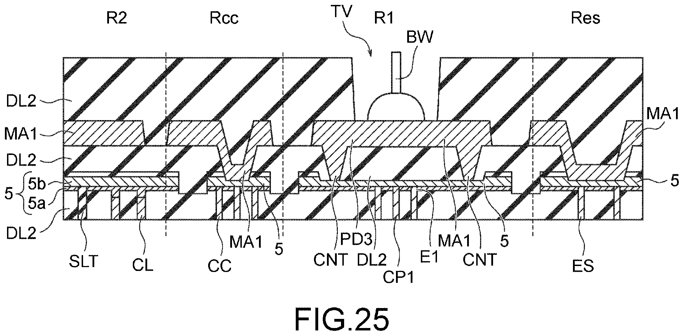

FIG. 25 is a cross-sectional view illustrating a configuration example of the semiconductor storage device 1 according to a fifth embodiment. In the fifth embodiment, in the region R1, the insulation film DL2 is provided between the contact plug CP1 and the pad PD3 (the wire MA1). The insulation film DL2 is provided above the end E1 of the contact plug CP1 and is provided between the conductive layer 5 and the pad PD3. Contacts CNT are provided on both sides of the insulation film DL2, respectively, and the pad PD3 is electrically connected to the conductive layer 5 via the contacts CNT.

Since the insulation film DL2 is provided below a connecting portion of the wire BW, impact of bonding of the wire BW can be further reduced. Therefore, damage to the contact plug CP1 by wire bonding can be further reduced. The rest of the configuration of the fifth embodiment may be identical to that of the first embodiment. Accordingly, the fifth embodiment can obtain effects identical to those of the first embodiment.

The fifth embodiment may be combined with any of the second to fourth embodiments. Accordingly, the fifth embodiment can also obtain effects of any of the second to fourth embodiments.

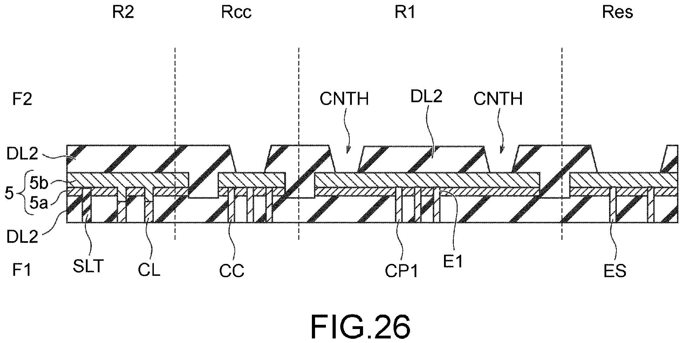

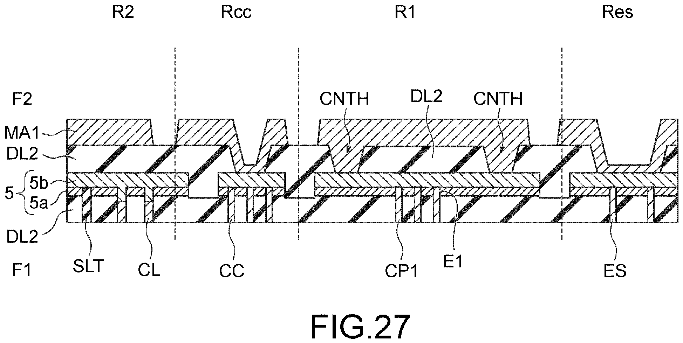

FIGS. 26 and 27 are cross-sectional views illustrating an example of a manufacturing method of the semiconductor storage device 1 according to the fifth embodiment. After the processes described with reference to FIGS. 9 to 13, in the process of forming the insulation film DL2 described with reference to FIG. 14, the insulation film DL2 is also left above the contact plug CP1 in the region R1. Accordingly, the structure illustrated in FIG. 26 is obtained. Contact holes CNTH for the contacts CNT are formed on both sides of the contact plug CP1 in the region R1, respectively.

Next, as illustrated in FIG. 27, the material for the wire MA1 is formed on the insulation film DL2 and the conductive layer 5. The material for the wire MA1 is formed on the conductive layer 5 in each of the regions R2, Rcc, R1, and Res. Next, the material for the wire MA1 is processed by lithography and etching. Accordingly, the wires MA1 on the memory cell array 21, the contact plugs CC and CP1 and the edge seal ES are electrically isolated. Further, in the region R1, the material for the wire MA1 is embedded in the contact holes CNTH, and the contacts CNT are formed on both sides of the insulation film DL2, respectively. The contacts CNT are connected to the conductive layer 5.

Thereafter, the material for the insulation film DL2 is further formed on the wire MA1, the opening TV is formed by removing the insulation film DL2 on the contact plug CP1 by lithography and etching, so that the pad PD3 is formed. By bonding the wire BW to the pad PD3, the semiconductor storage device 1 illustrated in FIG. 25 is completed.

### (Sixth embodiment)

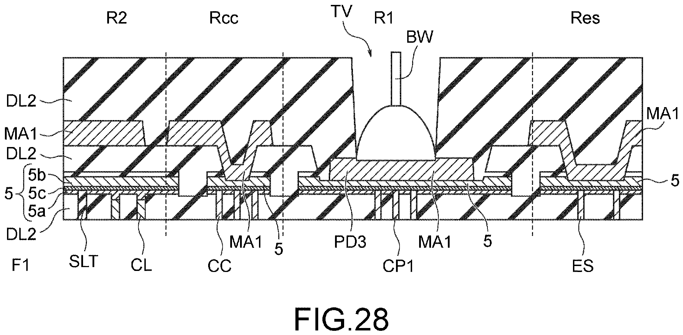

FIG. 28 is a cross-sectional view illustrating a configuration example of the semiconductor storage device 1 according to a sixth embodiment. In the sixth embodiment, the conductive layer 5 is a stacked film of the conductive layers 5a and 5b and a conductive layer 5c. The conductive layer 5c is provided between the conductive layer 5a and the conductive layer 5b and contains polysilicon, for example. The rest of the configuration of the sixth embodiment may be identical to that of the first embodiment. Accordingly, the sixth embodiment can obtain effects identical to those of the first embodiment.

In a manufacturing method according to the sixth embodiment, it suffices that in the first embodiment, the conductive layer 5c is formed, the conductive layer 5b is then formed, and the conductive layer 5c is processed in an identical manner to that of the conductive layer 5b.

### (Seventh embodiment)

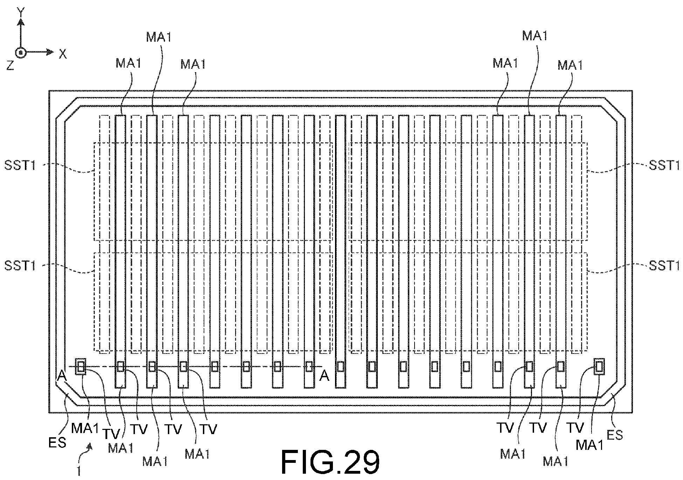

FIG. 29 is an X-Y plan view illustrating a configuration example of the semiconductor storage device 1 according to a seventh embodiment. The semiconductor storage device 1 can include the chip 10 and the chip 20 stacked on the chip 10. In the memory cell arrays 21 in the chip 20, the stacks SST1 are arranged, respectively. The stacks SST1 may be arranged two-dimensionally in the X- and Y-directions. Each stack SST1 has a substantially rectangular shape in plan view along the X-Y plane, in which the X-direction is assumed as the longitudinal direction, for example. Each stack SST1 functions as a portion of the memory cell array 21. The wires MA1 are arranged on the +Z-side of the stack SST1. The wires MA1 are arranged in the X-direction. Each wire MA1 extends in the Y-direction. Each wire MA1 extends in the Y-direction across the stack SST1 as viewed from the Z-direction. Each wire MA1 functions as the power line 22 or 23, and has the width and thickness in accordance with the amount of power to be transmitted and the extending length. Each wire MA1 is mostly covered with the insulation film DL2, and is partly exposed near its -Y-side end via the opening TV. Accordingly, each wire MA1 allows the wire BW described later in wire bonding to be bonded thereto via the opening TV. A cross-section when FIG. 29 is cut along a line A-A is illustrated in FIG. 4, for example.

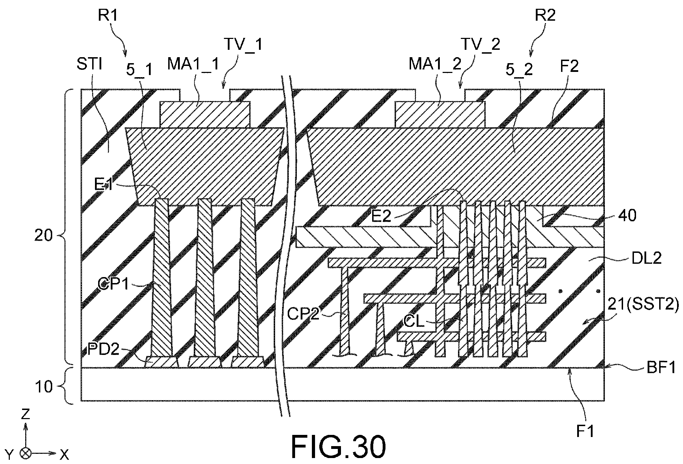

FIG. 30 is a cross-sectional view illustrating the configuration example of the semiconductor storage device 1 according to the seventh embodiment. FIG. 30 illustrates the region R1 of the contact plug CP1 and the region R2 of the memory cell array 21 side by side for the sake of convenience. Further, in order to distinguish the configurations in the R1 and R2 from each other, the conductive layer 5, the wire MA1, and the opening TV in the region R1 of the contact plug CP1 are denoted as a conductive layer 5_1, a wire MA1_1, and an opening TV_1, respectively, and the conductive layer 5, the wire MA1, and the opening TV in the region R2 of the memory cell array 21 are denoted as a conductive layer 5_2, a wire MA1_2, and an opening TV_2, respectively.

In the region R1 of the contact plug CP1, the contact plug CP1 extends in the Z-direction between the surface F1 and the surface F2 and is provided between the electrode PD2 and the conductive layer 5_1. The surface F2 side end E1 of the contact plug CP1 is located within the conductive layer 5_1 and does not reach the wire MA1_1. The wire MA1_1 is provided on the conductive layer 5_1 and is provided above the contact plug CP1 (directly above in the +Z-direction). The wire MA1_1 is electrically connected to the contact plug CP1 via the conductive layer 5_1. Since the end E1 of the contact plug CP1 does not reach the wire MA1_1, the wire MA1_1 can be formed on the surface of the conductive layer 5_1 which is substantially flat. Therefore, the surface of the wire MA1_1 is also substantially flat, so that the wire MA1_1 can function as a pad that allows wire bonding to be easily performed. The insulation film DL2 covers the wires MA1_1 and MA1_2 and exposes a portion of each of the wires MA1_1 and MA1_2 as a bonding pad. The opening TV_1 allows the portion of the wire MA1_1 to be exposed from the insulation film DL2 therethrough and allows the portion of the wire MA1_1 to function as a bonding pad.

In the region R2 of the memory cell array 21, the memory cell array 21 is provided between the surface F1 and the surface F2. The surface F2 side end E2 of the memory cell array 21 is located within the conductive layer 5_2 and does not reach the wire MA1_2. The wire MA1_2 is provided on the conductive layer 5_2 and is provided above the memory cell array 21 (directly above in the +Z-direction). The wire MA1_2 is electrically connected to the memory cell array 21 via the conductive layer 5_2. The opening TV_2 allows the portion of the wire MA1_2 to be exposed from the insulation film DL2 therethrough and allows the portion of the wire MA1_2 to function as a bonding pad.

The conductive layer 5_1 and the conductive layer 5_2 are provided in the same layer and contain the same material. Therefore, the conductive layer 5_1 and the conductive layer 5_2 have substantially the same height in the Z-direction and are easy to process. For example, monocrystalline silicon doped with N-type impurities may be used for the conductive layers 5_1 and 5_2. In this case, the conductive layers 5_1 and 5_2 may be semiconductor regions of a silicon substrate obtained by doping N-type impurities (for example, phosphorus or arsenic) into a silicon substrate, the semiconductor regions being electrically isolated from each other by an insulation isolator STI. The conductive layers 5_1 and 5_2 are electrically isolated from each other by the insulation isolator STI and each can function as a conductive layer. In addition, the conductive layers 5_1 and 5_2 can function as an etching stopper in the process of forming the contact plug CP1 or the columnar body CL.

Further, the wires MA1_1 and MA1_2 are provided in the same layer and contain the same material. Therefore, the wires MA1_1 and MA1_2 have substantially the same height in the Z-direction and are easy to process. For example, the wires MA1_1 and MA1_2 contain a low-resistance metal material such as aluminum. The wires MA1_1 and MA1_2 are electrically isolated from each other by the insulation film DL2 and each can function as a bonding pad. Since the wires MA1_1 and MA1_2 have substantially the same height, the heights in the Z-direction of the surfaces of the bonding pads of the wires MA1_1 and MA1_2 are also substantially the same as each other. Therefore, wire bonding can also be facilitated.

As described above, in the seventh embodiment, since the conductive layer 5_1 is provided between the wire MA1_1 and the contact plug CP1, protrusion of the end E1 of the contact plug CP1 does not appear in the surface of the wire MA1_1 as a bonding pad. With this configuration, although the wire MA1_1 is provided above the contact plug CP1, the surface of the wire MA1_1 is substantially flat, so that a structure making wire bonding easy is obtained. Consequently, a connection failure between a wire and the contact plug CP1 can be prevented.

Further, in the seventh embodiment, the wire MA1_1 can be arranged to overlap the portion above the contact plug CP1. Therefore, the size of the chip 10 can be made smaller.

Next, a manufacturing method of the semiconductor storage device 1 according to the seventh embodiment is described.

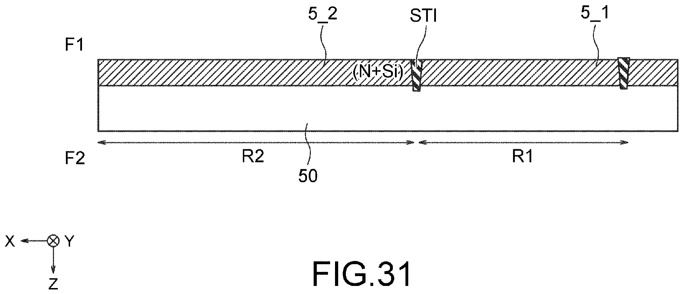

FIGS. 31 to 37 are cross-sectional views illustrating an example of the manufacturing method of the semiconductor storage device 1 according to the seventh embodiment. FIGS. 31 to 33 illustrate a manufacturing process of the chip 20 including the memory cell array 21.

First, as illustrated in FIG. 31, N-type impurities (for example, phosphorus or arsenic) are doped into a surface region of the substrate 50 on the surface F1 side by ion implantation or the like. The substrate 50 is a monocrystalline silicon substrate, for example. By doping N-type impurities, a monocrystalline silicon layer containing the N-type impurities is formed in the surface of the substrate 50. This monocrystalline silicon layer has a relatively high N-type impurity concentration. This monocrystalline silicon layer becomes the conductive layers 5_1 and 5_2 later.

Next, the monocrystalline silicon layer containing the N-type impurities (hereinafter, also "the N⁺ monocrystalline silicon layer") is processed by lithography and etching to form a trench for forming the insulation isolator STI. By embedding an insulation material in the trench, the insulation isolator STI is formed in the N⁺ monocrystalline silicon layer and isolates the N⁺ monocrystalline silicon layer. The insulation isolator STI isolates the N⁺ monocrystalline silicon layer in the region R1 in which the contact plug CP1 is to be formed and in the region R2 in which the memory cell array 21 is to be formed. An insulation material containing silicon and oxygen, for example, is used for the insulation isolator STI. Accordingly, the N⁺ monocrystalline silicon layer is formed in each of the region R1 in which the contact plug CP1 is to be formed and the region R2, apart from the region R1, in which the memory cell array 21 is to be formed.

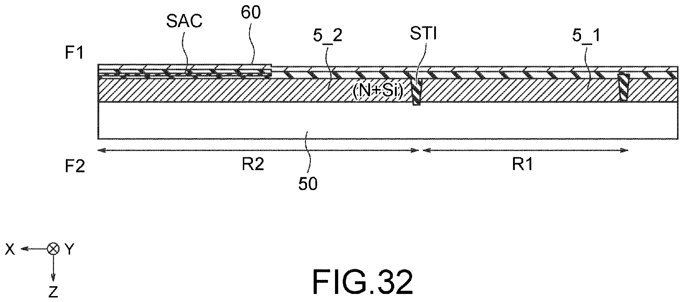

Next, as illustrated in FIG. 32, a sacrifice layer SAC including a film containing silicon and oxygen, a film containing silicon and nitrogen, and a film containing silicon and oxygen is formed on the substrate 50. The sacrifice layer SAC is replaced with the material (for example, polysilicon) for the cell source connected to the semiconductor film CH of the columnar body CL in a later process. Further, the material (for example, polysilicon) for the cell source is formed on the sacrifice layer SAC. Accordingly, the structure illustrated in FIG. 32 is obtained.

Next, the stack SST1 of the memory cell array 21 is formed. The illustrations of the process of forming the memory cell array 21 are omitted as appropriate.

The stack SST1 is formed by alternately stacking the insulation layer 4 (see FIG. 4) and a sacrifice film (not illustrated) on the sacrifice layer SAC on the surface F1 side of the substrate 50. At this stage, the conductive layer 3 (see FIG. 4) has not been formed yet, and the stack SST1 is a stack of the insulation layers 4 and the sacrifice films. A film containing silicon and nitrogen that can be selectively removed with respect to the insulation layer 4 is used for the sacrifice film, for example. A memory hole penetrating through the stack SST1 is then formed, so that the columnar body CL described with reference to FIG. 5 is formed in the memory hole.

Next, the stack SST1 is processed into a staircase shape by lithography and etching. Subsequently, the contact plug CP2 reaching the surface of each step of the staircase shape is formed.

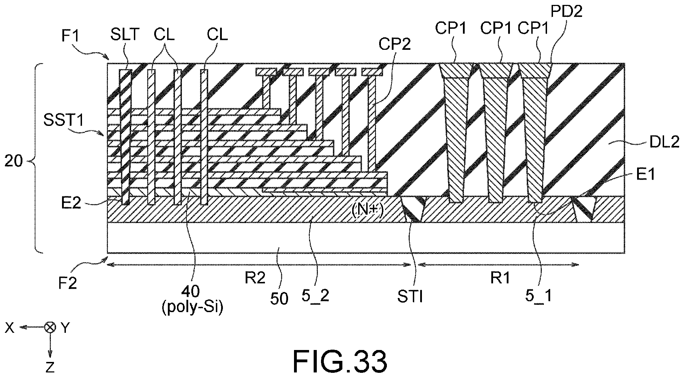

Next, the slit SLT penetrating through the stack SST1 in the Z-direction is formed, and the sacrifice layer SAC is removed via this slit SLT. Subsequently, the insulation film BLK2, the insulation film BLK1, the charge storage film CT, and the insulation film TNL around the semiconductor film CH of the columnar body CL are removed. The material for a conductive film 40 (for example, doped polysilicon) is embedded in a spatial region from which the sacrifice layer SAC has been removed and the sacrifice layer SAC is replaced with the material for the conductive film 40. Accordingly, the conductive film 40 illustrated in FIG. 33 is formed (a DSC process). The conductive film 40 is in direct contact with the semiconductor film CH of the columnar body CL at a lower end of the columnar body CL.

Next, the sacrifice films of the stack SST1 are replaced with the conductive layers 3 via the slit SLT. In this manner, the stack SST1 becomes a stack in which the conductive layer 3 and the insulation layer 4 are alternately stacked. The conductive layer 3 is provided around each columnar body CL and functions as a gate electrode of a memory cell. Further, the conductive layer 3 is connected to the corresponding contact plug CP2 and can receive a gate voltage from the contact plug CP2.

The slit SLT may be filled with an insulation film entirely. Alternatively, the slit SLT may be configured as a wire that is to be electrically connected to the conductive layer 5_2 while being insulated from the stack SST1, by forming a thin insulation film on the inner wall of the slit SLT and embedding a conductive body inside the insulation film. The stack SST1 of the memory cell array 21 is formed in this manner. The ends E2 of the columnar body CL and the slit SLT reach the conductive layer 5_2. However, since the conductive layer 5_2 includes the N⁺ monocrystalline silicon layer, the ends E2 remain in the conductive layer 5_2 without penetrating through the conductive layer 5_2.

Next, a contact hole reaching the conductive layer 5_1 is formed in the insulation film DL2 in the region R1, and a conductive material (for example, a metal material such as copper and tungsten) is embedded in the contact hole. Accordingly, the contact plug CP1 extending from the surface of the insulation film DL2 in the Z-direction and reaching the conductive layer 5_1 is formed. The end E1 of the contact plug CP1 reaches the conductive layer 5_1. However, since the conductive layer 5_2 includes the N⁺ monocrystalline silicon layer, the end E1 remains in the conductive layer 5_1 without penetrating through the conductive layer 5_1.

Next, the electrode PD2 is formed on the contact plug CP1. A metal material, for example, copper or tungsten is used for the electrode PD2. Accordingly, the structure of the chip 20 illustrated in FIG. 33 is obtained.

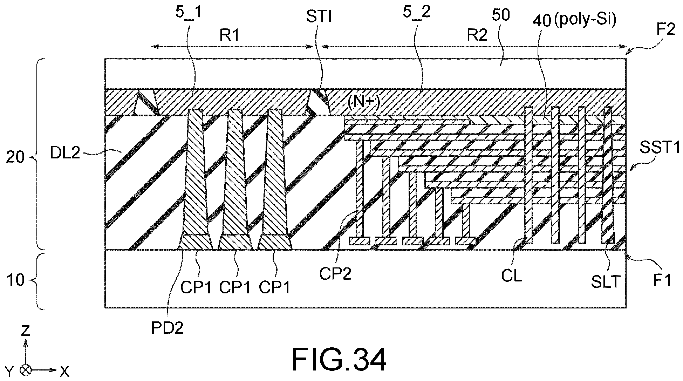

Next, the surface F1 of the chip 20 is bonded to the chip 10 as illustrated in FIG. 34. Accordingly, the electrode PD2 is bonded to a pad of the chip 10. The illustration of the internal configuration of the chip 10 is omitted in FIGS. 34 to 37. The configuration of the chip 10 has been described with reference to FIG. 4. Accordingly, the contact plug CP1 can electrically connect the conductive layer 5_1 and an element of the chip 10 to each other.

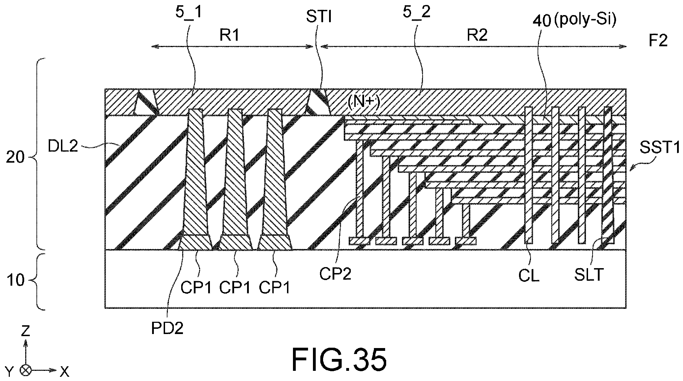

Next, as illustrated in FIG. 35, the substrate 50 is polished by CMP (Chemical Mechanical Polishing) or the like until the insulation isolator STI is exposed on the surface F2 side of the chip 20. Accordingly, the substrate 50 other than the substrate 50 on the conductive layers 5_1 and 5_2 is removed. At this time, the insulation isolator STI functions as a stopper in the CMP process. The conductive layers 5_1 and 5_2 are left, and are exposed on the surface F2 side while being electrically isolated from each other by the insulation isolator STI. At this time, since the end E1 of the contact plug CP1 remains in the conductive layer 5_1 without penetrating through the conductive layer 5_1, the surface F2 side surface of the conductive layer 5_1 is substantially flat. Further, since the ends of the columnar body CL and the slit SLT also remain in the conductive layer 5_2 without penetrating through the conductive layer 5_2, the surface F2 side surface of the conductive layer 5_2 is also substantially flat.

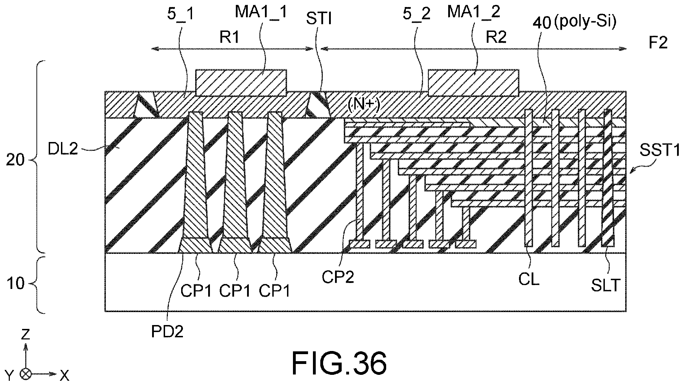

Next, as illustrated in FIG. 36, the material for the wires MA1_1 and MA1_2 (for example, a metal material such as aluminum) is formed on the conductive layers 5_1 and 5_2. Next, the wires MA1_1 and MA1_2 are processed by lithography and etching. Accordingly, the wires MA1_1 and MA1_2 are formed on the conductive layers 5_1 and 5_2 in the regions R1 and R2, respectively, while being isolated from each other. Since the surfaces of the conductive layers 5_1 and 5_2 are substantially flat, the surfaces of the wires MA1_1 and MA1_2 also become substantially flat. As illustrated in FIG. 3, the conductive layer 5_1 is provided in an island shape in the region R1 in which the contact plug CP1 is arranged. The conductive layer 5_2 is provided in a stripe shape in the region R2 in which the stack SST1 is arranged.

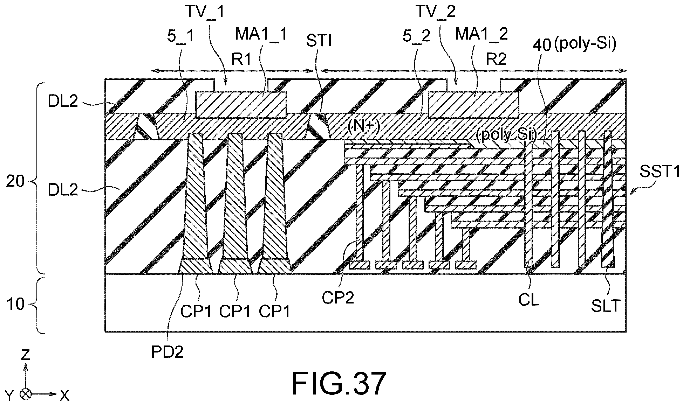

Next, as illustrated in FIG. 37, the insulation film DL2 is formed on the wires MA1_1 and MA1_2 and the conductive layers 5_1 and 5_2. The insulation film DL2 may be a film containing silicon and oxygen, for example.

Next, the insulation film DL2 on the wires MA1_1 and MA1_2 is partly removed by lithography and etching. Accordingly, the openings TV_1 and TV_2 are formed in the surfaces of the wires MA1_1 and MA1_2, respectively. That is, the conductive layer 5_1, the wire MA1_1, and the opening TV_1 are provided directly above the contact plug CP1 (in the +Z-direction). The wire MA1_1 exposed in the opening TV_1 functions as a bonding pad. The conductive layer 5_2, the wire MA1_2, and the opening TV_2 are provided above the stack SST1 (in the +Z-direction). The wire MA1_2 exposed in the opening TV_2 functions as a bonding pad.

Thereafter, the semiconductor storage device 1 according to the present embodiment is completed after a wire bonding process and the like.

As described above, according to the seventh embodiment, the conductive layer 5_1 formed by the substrate 50 (for example, the N⁺ monocrystalline silicon layer) is formed prior to formation of the contact plug CP1 and bonding to the chip 10. The conductive layer 5_1 covers the end E1 of the contact plug CP1, and the surface of the conductive layer 5_1 on the surface F2 side becomes substantially flat. Accordingly, the wire MA1_1 on the conductive layer 5_1 also becomes substantially flat, so that it is possible to easily form a bonding pad above the contact plug CP1.

Similarly to the conductive layer 5_1, the conductive layer 5_2 (for example, the N⁺ monocrystalline silicon layer) also receives the ends E2 of the columnar body CL and the slit SLT and this makes the surface of the conductive layer 5_2 substantially flat. Accordingly, the wire MA1_2 on the conductive layer 5_2 also becomes substantially flat, so that it is possible to easily form a bonding pad above the stack SST1.

In a case where the conductive layers 5_1 and 5_2 isolated from each other in advance by the insulation isolator STI are not provided, the conductive film 40 is provided at the end E1 of the contact plug CP1. The conductive film 40 made of polysilicon or the like is processed as the cell source CSL after the chip 20 is bonded to the chip 10. In this case, in processing of the cell source CSL and formation of the opening TV for a bonding pad, the end E1 of the contact plug CP1 is exposed in a convex shape, and the wire MA cannot be formed on the contact plug CP1 with good coverage. In this case, a bonding pad for the contact plug CP1 needs to be formed separately from the wire MA.

Meanwhile, according to the seventh embodiment, the conductive layer 5_1 covers the end E1 of the contact plug CP1. Since the conductive layer 5_1 has already been isolated from the conductive layer 5_2 by the insulation isolator STI, processing of the conductive layer 5_1 itself is not necessary after the chip 20 is bonded to the chip 10. In addition, since the conductive layer 5_1 includes a monocrystalline silicon layer, for example, the conductive layer 5_1 is not significantly etched even when the opening TV_1 is formed in the insulation film DL2 containing silicon and oxygen. Therefore, the surface of the conductive layer 5_1 on the surface F2 side can be kept substantially flat. Accordingly, the wire MA1_1 on the conductive layer 5_1 also becomes substantially flat, so that it is possible to easily form a bonding pad directly above the contact plug CP1. This configuration leads to downscaling of the semiconductor storage device 1.

Further, in the seventh embodiment, although the conductive layers 5_1 and 5_2 are electrically isolated from each other, they are formed by the same process in the same layer from the same material (for example, N⁺ monocrystalline silicon). Similarly, although the wires MA1_1 and MA1_2 are electrically isolated from each other, they are formed by the same process in the same layer from the same material (for example, a metal material such as aluminum). Accordingly, it is not necessary to form the conductive layers 5_1 and 5_2, the wires MA1_1 and MA1_2, and the openings TV_1 and TV_2 in the regions R1 and R2 separately from each other, and this leads to shortening of the manufacturing process.

Furthermore, in the seventh embodiment, the conductive layer 5_2 functioning as the cell source CSL is formed while being connected to the substrate 50, prior to formation of the columnar body CL and the slit SLT. Therefore, electric charges generated in the process of forming the memory hole of the columnar body CL or the slit SLT can be released from the conductive layer 5_2 to the substrate 50. Consequently, a conductive body connecting the conductive film 40 and the substrate 50 to each other, which has been provided for preventing arcing conventionally, can be omitted.

### (Material for conductive layer 5)

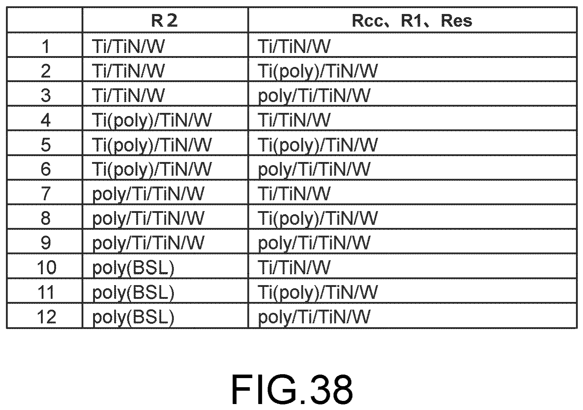

Various combinations of the materials for the conductive layer 5 are considered for the region R2 and the regions Rcc, R1, and Res. FIG. 38 is a table illustrating an example of combinations of the material for the conductive layer 5 in the region R2 and the material for the conductive layer 5 in the regions Rcc, R1, and Res.

A Ti/TiN/W film in FIG. 38 represents a stacked film of titanium (Ti), titanium nitride (TiN), and tungsten (W). Titanium (Ti) and titanium nitride (TiN) are used as a base (a barrier metal) of tungsten (W). For example, the conductive layer 5b in FIG. 19 includes a Ti/TiN/W film. The conductive layer 5b may be a single layer film of any of titanium (Ti), titanium nitride (TiN), and tungsten (W).

A Ti(poly)/TiN/W film represents a stacked film of a polysilicon film used as a stopper in formation of the contact plug CP1 or the like, and titanium (Ti), titanium nitride (TiN), and tungsten (W) stacked on the polysilicon film. For example, the conductive layer 5 in FIG. 6 is a stacked film including the conductive layer 5a containing polysilicon and the conductive layer 5b containing a Ti/TiN/W film.

A poly/Ti/TiN/W film represents a stacked film of a polysilicon film used as a stopper, another polysilicon film stacked thereon, and a Ti/TiN/W film. For example, the conductive layer 5 in FIG. 28 is a stacked film including the conductive layer 5a containing polysilicon, the conductive layer 5c stacked thereon and containing polysilicon, and the conductive layer 5b including a Ti/TiN/W film.

Regarding a poly film, the conductive layer 5 functioning as the cell source CSL of the memory cell array 21 contains polysilicon. For example, the conductive layer 5a contains polysilicon in the region R2 in FIG. 29. The conductive layer 5b includes a Ti/TiN/W film in the regions Rcc, R1, and Res. The poly film may be the conductive film 40 replaced in the above DSC process.

By combining these films for the region R2 and the regions Rcc, R1, and Res, the conductive layer 5 can be formed.

While certain embodiments have been described, these embodiments have been presented by way of example only and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

## Claims

1. A semiconductor storage device comprising:
a first chip including a transistor; and
a second chip including a memory cell array, wherein.
the second chip includes
a first surface bonded to the first chip,
a second surface opposite the first surface,
a contact extending between the first surface and the second surface and being provided apart from the memory cell array,
a first wiring layer provided above a first end of the contact and electrically connected to the contact, the first end being an end on a second surface side, and
a first conductive layer provided between the first end of the contact and the first wiring layer.

2. The device of Claim 1, wherein
the second chip further includes a second wiring layer provided between the memory cell array and the second surface and electrically connected to the memory cell array, and
the second wiring layer is provided in a same layer as the first wiring layer and contains a same material as the first wiring layer.

3. The device of Claim 2, wherein
the second ship further includes a second conductive layer provided between the memory cell array and the second wiring layer and electrically connected to the memory cell array, and
the second conductive layer is provided in a same layer as the first conductive layer and contains a same material as the first conductive layer.

4. The device of Claim 2 or 3, wherein the second chip further includes a first insulation layer that covers the first and second wiring layers, exposes a portion of the first wiring layer as a first pad, and exposes a portion of the second wiring layer as a second pad.

5. The device of Claim 2 or 3, wherein the second chip further includes a first insulation layer that covers the second wiring layer and exposes a portion of the second wiring layer as a second pad.

6. The device of any one of Claims 2 to 5, wherein the contact is overlapped by a connecting portion of a wire connected to the first pad as viewed from a direction perpendicular to the first surface.

7. The device of any one of Claims 2 to 5, wherein the contact is arranged around a connecting portion of a wire connected to the first pad as viewed from a direction perpendicular to the first surface.

8. The device of any one of Claims 1 to 7, wherein the first conductive layer contains any of polysilicon containing impurities, titanium, titanium nitride, and tungsten.

9. The device of any one of Claims 1 to 8, wherein the second conductive layer contains any of polysilicon containing impurities, titanium, titanium nitride, and tungsten.

10. The device of any one of Claims 1 to 9, wherein a material for the first conductive layer is different from a material for the second conductive layer.

11. The device of any one of Claims 1 to 10, further comprising a second insulation film provided above the contact between the first conductive layer and the first wiring layer.

12. The device of any one of Claims 1 and 3 to 9, wherein the first conductive layer contains monocrystalline silicon containing impurities.

13. The device of Claim 12, wherein the first end is located in the first conductive layer.

14. A manufacturing method of a semiconductor storage device that includes a first chip including a transistor and a second chip including a memory cell array, the method comprising:
forming the second chip including a contact and the memory cell array by using a substrate;
bonding the first chip to a first surface of the second chip, the first surface being opposite the substrate;
removing the substrate on a second surface of the second chip opposite the first surface;
forming first and second conductive layers, electrically insulated from each other, above the contact and the memory cell array on a second surface side of the second chip, respectively; and
forming first and second wiring layers, electrically insulated from each other, on the first and second conductive layers, respectively, wherein
the forming of the second chip includes
forming the contact on a first region of the substrate, and
forming the memory cell array on the second region of the substrate apart from the first region.

15. The method of Claim 14, further comprising, prior to the forming of the contact and the memory cell array, forming a material film on the first and second regions of the substrate, wherein
in the forming of the contact and the memory cell array, the contact and the memory cell array are formed by using the material film as an etching stopper, and
in the forming of the first and second conductive layers, the first and second conductive layers are formed on the material film.

16. The method of Claim 14, wherein a single-layer film or a stacked film containing any of polysilicon that contains impurities, titanium, titanium nitride, and tungsten is used for the first conductive layer.

17. The method of Claim 14, wherein a single-layer film or a stacked film containing any of polysilicon that contains impurities, titanium, titanium nitride, and tungsten is used for the second conductive layer.

18. A manufacturing method of a semiconductor storage device that includes a first chip including a transistor and a second chip including a memory cell array, the method comprising:
forming the second chip by using a substrate including first and second semiconductor regions;
bonding the first chip to a first surface side of the second chip, the first surface side being opposite the substrate;
removing the substrate other than the substrate on the first and second semiconductor regions on a second surface side of the second chip opposite the first surface; and
forming first and second wiring layers on the first and second semiconductor regions, respectively, wherein
the forming of the second chip includes
forming the first semiconductor region in which a contact is to be formed and the second semiconductor region, apart from the first semiconductor region, in which the memory cell array is to be formed by doping impurities into the substrate and by forming an insulation isolator on the substrate, and
forming the memory cell array to be connected to the second semiconductor region on the second semiconductor region and forming the contact reaching the first semiconductor region on the first semiconductor region.

19. The method of Claim 18, further comprising:
forming an insulation film on the first and second wiring layers; and
forming openings in a portion of the insulation film to expose a portion of the first wiring layer as a first pad and expose a portion of the second wiring layer as a second pad.

20. The method of Claim 18, wherein monocrystalline silicon containing impurities is used for the first and second semiconductor regions.
